(19) Europäisches Patentamt / European Patent Office / Office européen des brevets

(11) **EP 4 650 764 B1**

(12) **EUROPEAN PATENT SPECIFICATION**

(45) Date of publication and mention of the grant of the patent:
**29.04.2026 Bulletin 2026/18**

(21) Application number: **24175492.8**

(22) Date of filing: **13.05.2024**

(51) International Patent Classification (IPC):
*G01N 24/08* (2006.01)   *G01R 33/345* (2006.01)
*G01R 33/44* (2006.01)   *G01R 33/46* (2006.01)

(52) Cooperative Patent Classification (CPC):
**G01N 24/08; G01R 33/3456; G01R 33/44; G01R 33/46;** G01N 24/087

(54) **ENANTIOMERIC DISCRIMINATION BY NMR**

UNTERSCHEIDUNG VON ENANTIOMEREN MITTELS NMR

DISCRIMINATION D'ENANTIOMERES PAR RMN

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**19.11.2025 Bulletin 2025/47**

(73) Proprietors:
- **Voxalytic GmbH**
  **76228 Karlsruhe (DE)**
- **Karlsruher Institut für Technologie**
  **76131 Karlsruhe (DE)**

(72) Inventors:
- **Korvink, Jan**
  **76228 Karlsruhe (DE)**
- **Wadhwa, Sagar**
  **76131 Karlsruhe (DE)**

(74) Representative: **Müller-Boré & Partner**
**Patentanwälte PartG mbB**
**Friedenheimer Brücke 21**
**80639 München (DE)**

(56) References cited:
**EP-A1- 1 750 119     EP-A1- 3 719 521**

- BUCKINGHAM A D: "Chirality in NMR spectroscopy", CHEMICAL PHYSICS LETTERS, ELSEVIER BV, NL, vol. 398, no. 1-3, 28 September 2004 (2004-09-28), pages 1 - 5, XP004604142, ISSN: 0009-2614, DOI: 10.1016/ J.CPLETT.2004.08.046

- BUCKINGHAM A D ET AL: "Direct chiral discrimination in NMR spectroscopy", CHEMICAL PHYSICS, NORTH-HOLLAND, NL, vol. 324, no. 1, 9 May 2006 (2006-05-09), pages 111 - 116, XP027920285, ISSN: 0301-0104, [retrieved on 20060509]
- VAN BENTUM ET AL: "Stripline probes for nuclear magnetic resonance", JOURNAL OF MAGNETIC RESONANCE, ACADEMIC PRESS, ORLANDO, FL, US, vol. 189, no. 1, 7 September 2007 (2007-09-07), pages 104 - 113, XP022327804, ISSN: 1090-7807, DOI: 10.1016/ J.JMR.2007.08.019
- SAGAR WADHWA ET AL: "Direct Chiral Discrimination with NMR", ADVANCED MATERIALS, VCH PUBLISHERS, DE, vol. 36, no. 40, 23 August 2024 (2024-08-23), pages n/a, XP072709725, ISSN: 0935-9648, DOI: 10.1002/ ADMA.202408547
- JONATHAN P KING ET AL: "Antisymmetric Couplings Enable Direct Observation of Chirality in Nuclear Magnetic Resonance Spectroscopy", ARXIV.ORG, CORNELL UNIVERSITY LIBRARY, 201 OLIN LIBRARY CORNELL UNIVERSITY ITHACA, NY 14853, 1 September 2016 (2016-09-01), XP080723780

**Description**

The present invention relates to an NMR detector assembly for discriminating the enantiomers of a chiral substance contained in a sample. Further, the present invention relates to a corresponding method and to a corresponding computer-program product for discriminating the enantiomers of a chiral substance contained in a sample, which employ said NMR detector assembly.

By definition, a chiral molecule is a type of molecule that has a non-superposable mirror image. The feature that is most often the cause of chirality in molecules is the presence of one or more asymmetric carbon atoms without, however, being limited thereto. The two mirror images of a chiral molecule are called enantiomers. Being a fundamental property of its structure, the chirality of a molecule can have a crucial impact on its function in (bio)chemical reactions. It is estimated that half of the drugs currently synthesized in the pharmaceutical industry are chiral in nature, in which the therapeutic effects associated with one enantiomeric form are not necessarily reproduced by its mirror image. Thus, it is important in drug development to discriminate the enantiomer having the desired biological activity from its inactive, or in some cases, toxic counterpart, such as in the case of thalidomide, which is known for the infamous thalidomide scandal.

For discriminating the enantiomers of a chiral substance, various different techniques have been reported in the art.

One of these techniques is based on the phenomenon of optical rotation. A substance comprised of a chiral molecule, hereinafter simply referred to as chiral substance, can change the orientation of monochromatic linearly polarized light as the light passes through a sample containing the chiral substance. For this reason, a chiral molecule is said to be optically active. While one of the enantiomers rotates the plane of polarization clockwise, the other one of the enantiomers rotates the plane of polarization counter-clockwise. For a given chiral substance, the angle by which the plane of polarization is rotated at a specified wavelength is *inter alia* proportional to the concentration of the respective enantiomer contained in the sample. Hence, if the enantiomers of the chiral substance are present in the sample in equal amounts, i.e., are present in the sample as a racemic mixture, their effects cancel out and no optical activity can be observed. In case the sample under investigation contains more than one chiral substance, each of them contributes to the angle by which the plane of polarization is rotated with the result that the applicability of this technique is often limited.

Another technique called circular dichroism makes use of circularly polarized light. It is based on the phenomenon that a chiral molecule preferentially absorbs one direction of circularly polarized light. The difference in absorption of the left and right circularly polarized light can be measured, quantified, and represented as an absorption spectrum. As a prerequisite for circular dichroism, the sample under investigation must exhibit a sufficient molar extinction coefficient for the wavelength(s) of the circularly polarized light. As a consequence, circular dichroism may not be applicable in certain cases.

Further, there is known a technique which involves mass spectrometry in combination with a high-field ion mobility generator. It relies on alternating current excitations to induce rotational trajectories in which each of the enantiomeric ions trapped by using background gas molecules experiences a distinct collision behavior. Measuring the differences in collision cross section allows to discriminate the enantiomers. However, as usual in mass spectrometry, the sample is irreversibly lost.

Due to its significance for structure elucidation, attempts have been made to exploit nuclear magnetic resonance (NMR) for discriminating the enantiomers of a chiral substance. In order to do so, since NMR spectroscopy is considered incapable of discriminating the two mirror images as the nuclear shielding tensor responsible for chemical shifts due to the Zeeman effect is even under parity, the enantiomers are converted into non-mirror image stereoisomers, i.e., are converted into diastereomers. Discrimination of diastereomers by NMR spectroscopy is relatively straightforward as the NMR spectra of diastereomers are intrinsically different as a result of the different chemical environment the nuclei in diastereomers are exposed to, leading to differences in nuclear shielding. Conversion of enantiomers into diastereomers is achieved using chiral derivatizing agents or chiral solvating agents. Being enantiomerically pure, these agents convert the enantiomers into diastereomers either by chemical reaction in case of chiral derivatizing agents or by formation of a strong complex in case of chiral solvating agents. Even though the use of a chiral agent allows to discriminate the enantiomers of a chiral substance, such technique suffers from peak overlap between the chiral agent and the chiral substance. Besides, additional purification steps may be required to recover the chiral substance, which is cumbersome in many instances. Buckingham et al. discuss direct chiral discrimination in NMR spectroscopy (Chemical Physics, vol. 324, 2006, pages 111-116).

Accordingly, there exists a need for novel approaches which overcome the drawbacks of the techniques reported in the art for discriminating the enantiomers of a chiral substance.

The above technical problem underlying the present invention has been solved by providing the subject matter set out in the appended claims.

In one aspect, the present invention provides an NMR detector assembly for discriminating the enantiomers of a chiral substance contained in a sample, the NMR detector assembly being adapted to be inserted in an NMR spectrometer and comprising:

a first set of striplines, a second set of striplines and a sample probing region,

the NMR detector assembly being adapted to create a time-dependent RF magnetic field $B_1(t)$ in the form of an RF magnetic field pulse along the direction of the RF magnetic field $B_1(t)$ by means of the first set of striplines such that the net magnetisation of the sample is flipped from its initial position along the direction of the static magnetic field $B_0$ of the NMR spectrometer by an angle $\theta \neq (k - 1/2) \times \pi$, k being a nonzero positive integer,

and adapted to create a time-dependent RF electric field $E_2(t)$ perpendicular to the RF magnetic field $B_1(t)$ in the form of an RF electric field pulse along the direction of the RF electric field $E_2(t)$ simultaneously with the RF magnetic field pulse along the direction of the RF magnetic field $B_1(t)$ by means of the second set of striplines;

**the sample** probing region being located at the intersection of the RF magnetic field $B_1(t)$ and the RF electric field $E_2(t)$,

wherein the NMR detector assembly is adapted to be inserted in the NMR spectrometer in such a way that each of the RF magnetic field $B_1(t)$ and the RF electric field $E_2(t)$ are perpendicular to the static magnetic field $B_0$ of the NMR spectrometer in the sample probing region.

The above-defined NMR detector assembly for discriminating the enantiomers of a chiral substance contained in a sample, hereinafter simply referred to as NMR detector assembly according to the present invention, allows to discriminate the enantiomers of a chiral substance without the need of any chiral derivatizing agents or chiral solvating agents.

Generally, the enantiomers of a chiral substance have a permanent electric dipole moment that may couple with the nuclear spins. Thus, applying an RF electric field pulse simultaneously with the RF magnetic field pulse applied for flipping the net magnetisation of the sample from its initial position along the direction of the static magnetic field $B_0$ of the NMR spectrometer leads to a coupling due to the reciprocity principle between electric and magnetic dipoles. Having odd parity, the coupling tensor is space-dependent, which means that the coupling varies with the molecular structure and is different for the enantiomers of the chiral substance. In other words, the coupling is chirality-dependent. As a result, the coupling between the electric and magnetic dipoles when applying an RF electric field pulse simultaneously with the RF magnetic field pulse gives rise to a chiral perturbation which is characterized by different spin dynamics of the enantiomers.

As found by the present inventors, when the net magnetisation of the sample is flipped from its initial position along the direction of the static magnetic field $B_0$ of the NMR spectrometer by an angle $\theta \neq (k - 1/2) \times \pi$, k being a nonzero positive integer, an enantiomerically induced change in net signal phase arises due to the chiral perturbation. By detecting the same, it is possible to discriminate the enantiomers of the chiral substance. Further, since the configuration of the NMR detector assembly according to the present invention is stripline-based, which makes it possible to independently control the RF magnetic field and the RF electric field, the magnitudes thereof can be adjusted to achieve favorable experimental conditions while at the same time minimizing any stray electric and magnetic fields, which would otherwise impair the detection of the enantiomerically induced change in net signal phase.

Accordingly, along with the specific pulse sequence applied, it is the specific stripline-based configuration of the NMR detector assembly which solves the above technical problem underlying the present invention.

In the following, the NMR detector assembly according to the present invention will be described in detail.

The NMR detector assembly according to the present invention is adapted to be inserted in an NMR spectrometer. Herein, adapted to be inserted in an NMR spectrometer means that the NMR detector assembly according to the present invention can be arranged between the poles of the static magnetic field $B_0$ of the NMR spectrometer. For this purpose, the NMR detector assembly may be mounted on an NMR probehead, which facilitates its insertion in the NMR spectrometer and provides for the electrical connections. Apart from this, there are no specific limitations to be mentioned for the NMR spectrometer. That is, any commercially available NMR spectrometer that is routinely used for structure elucidation can also be used for the object of the present invention.

The NMR detector assembly according to the present invention comprises a first set of striplines, a second set of striplines, and a sample probing region.

In recent years, striplines have turned out to be a promising alternative to solenoid coils for NMR detection, see "Stripline probes for nuclear magnetic resonance", P. J. M. van Bentum et al., Journal of Magnetic Resonance 189 (2007) 104-113. Following Maxwell's equations, generating a high radiofrequency (RF) current density close to the sample probing region is the only requirement for creating a strong RF magnetic field in the sample volume. While a helix is a convenient configuration, it is by far not the only one. Striplines depart from the idea of a helical structure to create the RF magnetic field in that the current is fed through a thin metal strip. When two striplines are arranged in a parallel manner, the RF magnetic field obtained is characterized by high homogeneity. The RF magnetic field may be confined by symmetrically arranging ground planes both above and below the striplines.

Herein, two striplines are combined to obtain a first set of striplines. By inductively-tuning the first set of striplines, a strong time-dependent RF magnetic field $B_1$

(t) can be created while any stray electric field can be minimized at the same time.

Apart from creating strong RF magnetic fields, striplines can also be used for creating strong RF electric fields. When two striplines are arranged in a parallel manner, the RF electric field obtained is characterized by high homogeneity. The RF electric field is intrinsically confined between the striplines.

Herein, two striplines are combined to obtain a second set of striplines. By capacitively-tuning the second set of striplines, a strong time-dependent RF electric field $E_2(t)$ can be created while any stray magnetic field can be minimized at the same time.

According to the present invention, the RF electric field $E_2(t)$ is perpendicular to the RF magnetic field $B_1(t)$. Typically, to provide for the orthogonality of the RF magnetic field $B_1(t)$ and the RF electric field $E_2(t)$, the first set of striplines and the second set of striplines are arranged in a stacked manner in such a way that the striplines of the second set of striplines are arranged outside and the striplines of the first set of striplines are arranged inside of the stack.

In addition to the first set of striplines and the second set of striplines, the NMR detector assembly according to the present invention comprises a sample probing region. The sample probing region is located at the intersection of the RF magnetic field $B_1(t)$ and the RF electric field $E_2(t)$. The dimension of the sample probing region must be such that the sample containing the chiral substance can be placed into it. The sample itself may be stored in a container suitable for NMR spectroscopy, such as a sealed glass capillary or the like. When arranged in a stacked manner, the first set of striplines and the second set of striplines symmetrically sandwich the sample probing region, the first set of striplines being closer to the sample probing region than the second set of striplines.

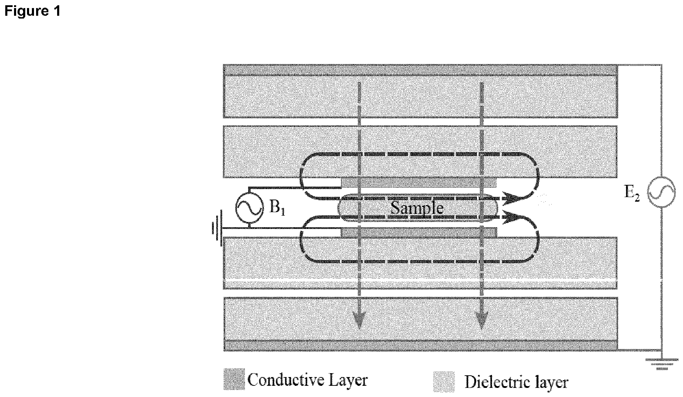

**Figure** 1 shows a schematic of an exemplary NMR detector assembly according to the present invention, which is implemented by precision printed circuit board technology as a stack of four striplines sandwiching the sample probing region. As can be taken from **Figure** 1, the inner conductive layers correspond to the first set of striplines, creating the time-dependent RF magnetic field $B_1(t)$, while the outer conductive layers correspond to the second set of striplines, creating the time-dependent RF electric field $E_2(t)$. Due to this arrangement, the RF electric field $E_2(t)$ is strictly perpendicular to the RF magnetic field $B_1(t)$ in the sample probing region located at the intersection of the RF magnetic field $B_1(t)$ and the RF electric field $E_2(t)$.

The dimensions of the first set of striplines, i.e., its length and width, are governed by the Larmor frequency at which the nuclei precess around the direction of the static magnetic field $B_0$ of the NMR spectrometer, taking into account that the first set of striplines creating the RF magnetic field $B_1(t)$ must be resonant at the Larmor frequency. In other words, depending on the magnitude of the static magnetic field $B_0$, which in turn affects the Larmor frequency of the nuclei, the dimensions of the first set of striplines are set accordingly.

Regarding the second set of striplines creating the RF electric field $E_2(t)$, it is preferred that the size of the second set of striplines is such that it covers at least the entire length and width of the first set of striplines, as shown in **Figure** 1. Thereby, it is ensured that not only the RF magnetic field $B_1(t)$ but also the RF electric field $E_2(t)$ is almost uniform across the entire sample probing region so that all nuclei in the sample experience the same magnitude of the RF magnetic field $B_1(t)$ and the same magnitude of the RF electric field $E_2(t)$.

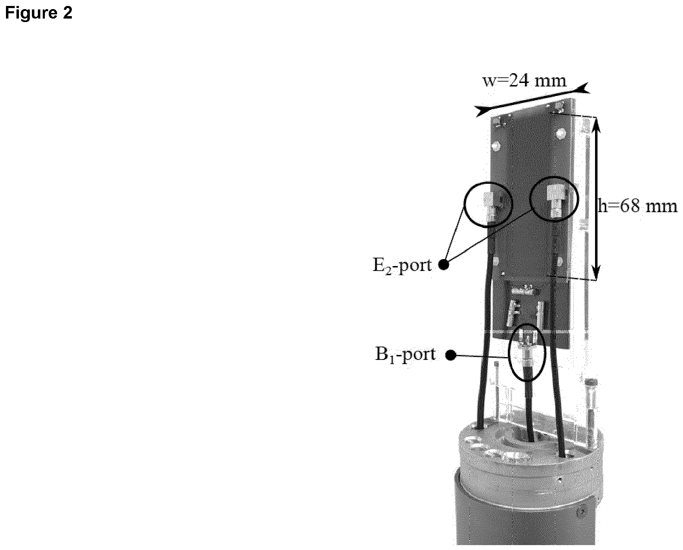

**Figure** 2 shows a photograph of an exemplary NMR detector assembly according to the present invention, which has the setup illustrated in **Figure** 1. The NMR detector assembly is mounted on a customized NMR probehead. The excitation of the first set of striplines and the excitation of the second set of striplines are accomplished via RF ports, referred to as $B_1$-port and $E_2$-ports in **Figure 2,** respectively. Thereby, both the first set of striplines and the second set of striplines can be electrically tuned to retain their RF properties across a wide band of frequencies. Suitably, the position of the RF ports is such that any field gradients are reduced.

The time-dependent RF magnetic field $B_1(t)$ created by the first set of striplines allows to apply an RF magnetic field pulse along the direction of the RF magnetic field $B_1(t)$. Likewise, the time-dependent RF electric field $E_2(t)$ created by the second set of striplines allows to apply an RF electric field pulse along the direction of the RF electric field $E_2(t)$. When inserting the NMR detector assembly according to the present invention in the NMR spectrometer, each of the RF magnetic field $B_1(t)$ and the RF electric field $E_2(t)$ are perpendicular to the static magnetic field $B_0$ of the NMR spectrometer in the sample probing region. That is, the relation $B_0 \perp B_1 \perp E_2$ applies in the sample probing region.

Regarding the magnitude of the RF magnetic field $B_1(t)$, it must be such that the RF magnetic field pulse to be applied along the direction of the RF magnetic field $B_1(t)$ can flip the net magnetisation of the sample from its initial position along the direction of the static magnetic field $B_0$ of the NMR spectrometer by an angle $\theta \neq (k - 1/2) \times \pi$, k being a nonzero positive integer, as discussed below in more detail in connection with the method according to the present invention.

Regarding the magnitude of the RF electric field $E_2(t)$, it should be relatively high in view of the low magnitude of the space-dependent coupling tensor compared to the magnetisation due to the Zeeman effect. In this context, it is noted that the odd parity term which is responsible for the different spin dynamics of the enantiomers is proportional to the magnitude of the RF electric field $E_2(t)$. On the other hand, an RF electric field $E_2(t)$ having an excessively high magnitude might lead to an electrical breakdown. For this reason, the second set of striplines may be adapted to create the RF electric field $E_2$

(t) up to the minimum dielectric strength of the medium through which the RF electric field $E_2(t)$ passes. By arranging dielectric layers between the first set of striplines and the second set of striplines, as shown in **Figure** 1, the minimum dielectric strength of the medium through which the RF electric field $E_2(t)$ passes can be increased. As a result, also the magnitude of the RF electric field $E_2(t)$ can be increased.

According to the present invention, the first set of striplines and the second set of striplines are adapted in such a way that the RF electric field pulse along the direction of the RF electric field $E_2(t)$ is applied simultaneously with the RF magnetic field pulse along the direction of the RF magnetic field $B_1(t)$. That is, the RF electric field pulse has the same temporary onset as the RF magnetic field pulse. It may be as long as or shorter than the RF magnetic field pulse. For this purpose, the NMR detector assembly according to the present invention may be adapted in such a way that the first set of striplines and the second set of striplines are electrically controlled individually.

Flipping the net magnetisation of the sample from its initial position along the direction of the static magnetic field $B_0$ of the NMR spectrometer results in a non-equilibrium state of the nuclear spins. This non-equilibrium state is characterized in that the precession of the nuclei around the direction of the static magnetic field $B_0$ becomes coherent. In a process called relaxation, the nuclear spins return to equilibrium while dephasing. As a result, the coherence vanishes so that the nuclei precess again randomly around the direction of the static magnetic field $B_0$ at the Larmor frequency. The relaxation is associated with a free induction decay (FID). By recording the same, it is possible to detect a change in net signal phase along the direction of the RF magnetic field $B_1(t)$. Being capable of recording the FID, the first set of striplines may be further adapted to detect a change in net signal phase along the direction of the RF magnetic field $B_1(t)$. Then, the first set of striplines acts both as an RF transmitter and as an RF receiver. Preferably, the NMR detector assembly according to the present invention does not contain any means for detecting a change in net signal phase other than the first set of striplines. By detecting a change in net signal phase along the direction of the RF magnetic field $B_1(t)$, it is possible to discriminate the enantiomers of a chiral substance, as discussed below in more detail in connection with the method according to the present invention.

In another aspect, the present invention provides a method for discriminating the enantiomers of a chiral substance contained in a sample, the method comprising the following steps:

(a) placing the sample containing the chiral substance into the sample probing region of the NMR detector assembly according to the present invention, and inserting the NMR detector assembly in the NMR spectrometer in such a way that each of the RF magnetic field $B_1(t)$ and the RF electric field $E_2(t)$ are perpendicular to the static magnetic field $B_0$ of the NMR spectrometer in the sample probing region;

(b) applying, by means of the first set of striplines of the NMR detector assembly, an RF magnetic field pulse along the direction of the RF magnetic field $B_1(t)$ to flip the net magnetisation of the sample from its initial position along the direction of the static magnetic field $B_0$ of the NMR spectrometer by an angle $\theta \neq (k - 1/2) \times \pi$, k being a nonzero positive integer;

(c) applying, by means of the second set of striplines of the NMR detector assembly, an RF electric field pulse along the direction of the RF electric field $E_2(t)$ simultaneously with the RF magnetic field pulse along the direction of the RF magnetic field $B_1(t)$;

(d) detecting, by means of a detection unit, a change in net signal phase along the direction of the RF magnetic field $B_1(t)$; and

(e) discriminating, by means of a discrimination unit, the enantiomers of the chiral substance based on the change in net signal phase detected.

The above-defined method for discriminating the enantiomers of a chiral substance contained in a sample, hereinafter simply referred to as method according to the present invention, employs the NMR detector assembly according to the present invention. Thus, wherever applicable, for the method according to the present invention, the same definitions and limitations apply as given above for the NMR detector assembly according to the present invention, and *vice versa*.

In the following, the method according to the present invention will be described in detail.

In step (a) of the method according to the present invention, the sample containing the chiral substance is placed into the sample probing region of the NMR detector assembly according to the present invention, and the NMR detector assembly is inserted in the NMR spectrometer. As mentioned above, the NMR detector assembly may be mounted on an NMR probehead, which facilitates its insertion in the NMR spectrometer and provides for the electrical connections. The insertion is done in such a way that each of the RF magnetic field $B_1(t)$ and the RF electric field $E_2(t)$ are perpendicular to the static magnetic field $B_0$ of the NMR spectrometer in the sample probing region. The sample itself may be stored in a container suitable for NMR spectroscopy, such as a sealed glass capillary or the like, further to what has been mentioned above. The sample containing the chiral substance may be placed into the sample probing region of the NMR detector assembly before or after inserting the NMR detector assembly in the NMR spectrometer.

In step (b) of the method according to the present invention, an RF magnetic field pulse along the direction of the RF magnetic field $B_1(t)$ is applied by means of the first set of striplines of the NMR detector assembly, the first set of striplines creating the time-dependent RF magnetic field $B_1(t)$. The RF magnetic field pulse is applied in such a way that the net magnetisation of the sample is flipped from its initial position along the direction of the static magnetic field $B_0$ of the NMR spectrometer by an angle $\theta \neq (k - 1/2) \times \pi$, k being a nonzero positive integer. In step (c) of the method according to the present invention, simultaneously with the RF magnetic field pulse along the direction of the RF magnetic field $B_1(t)$, an RF electric field pulse along the direction of the RF electric field $E_2(t)$ is applied by means of the second set of striplines of the NMR detector assembly, the second set of striplines creating the time-dependent RF electric field $E_2(t)$. Being applied simultaneously, the RF electric field pulse has the same temporary onset as the RF magnetic field pulse. As mentioned above, the RF electric field pulse may be as long as or shorter than the RF magnetic field pulse. Preferably, the length of the RF magnetic field pulse and the length of the RF electric field pulse are equal, which ensures that the enantiomerically induced change in net signal phase can be accumulated.

In this context, it is recalled that the odd parity term which is responsible for the different spin dynamics of the enantiomers is proportional to the magnitude of the RF electric field $E_2(t)$. Thus, in view of the low magnitude of the space-dependent coupling tensor compared to the magnetisation due to the Zeeman effect, the RF electric field $E_2(t)$ may be up to the minimum dielectric strength of the medium through which the RF electric field $E_2(t)$ passes.

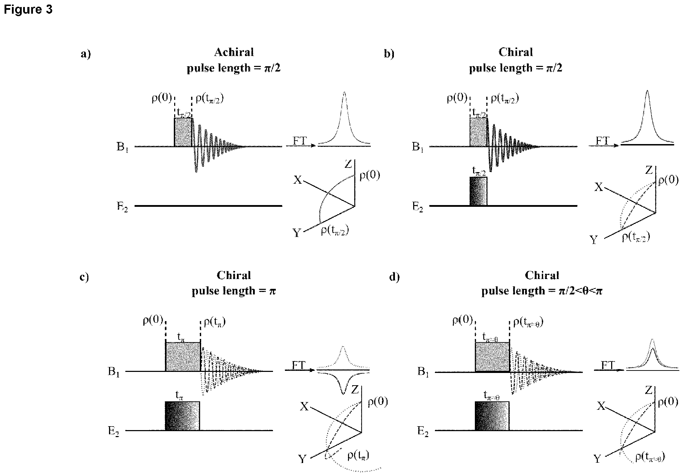

With k being a nonzero positive integer, the angle $\theta$ does not amount to $1/2\pi$, $3/2\pi$, $5/2\pi$, etc. In other words, the RF magnetic field pulse applied along the direction of the RF magnetic field $B_1(t)$ is not a $1/2\pi$-pulse, a $3/2\pi$-pulse, a $5/2\pi$-pulse, etc. The reason why the angle $\theta \neq (k - 1/2) \times \pi$, k being a nonzero positive integer, is explained in the following by making reference to **Figure 3.**

**Figure** 3 shows the evolution of net magnetisation for different scenarios after applying the RF magnetic field pulse along the direction of the RF magnetic field $B_1(t)$, corresponding to the Y-axis, and further shows the respective NMR spectra obtained after conducting Fourier transformation (FT) on the respective FID recorded. In each case, the enantiomers of the chiral substance are present in the sample as a racemic mixture. The density of states is labelled as $\rho$ in Figure 3.

Figure 3a) represents the case when only the RF magnetic field pulse is applied along the direction of the RF magnetic field $B_1(t)$, as in conventional NMR spectroscopy, where the RF magnetic field pulse applied is a $\pi/2$-pulse. The $\pi/2$-pulse flips the net magnetisation of the sample from its initial position along the direction of the static magnetic field $B_0$, corresponding to the Z-axis, into the transversal XY-plane parallel to the Y-axis. The FID recorded is the same for the two enantiomers of the chiral substance. As a result, the NMR spectrum obtained after conducting FT on the FID recorded is also the same for the two enantiomers of the chiral substance. Consequently, discrimination of the enantiomers is not possible.

Figures 3b), c) and d) represent the case when the RF electric field pulse along the direction of the RF electric field $E_2(t)$ is applied simultaneously with the RF magnetic field pulse along the direction of the RF magnetic field $B_1(t)$. As can be taken from Figures 3b), c) and d), due to the coupling between the electric and magnetic dipoles, a small deflection torque is imposed onto the net magnetisation when it is flipped from its initial position along the direction of the static magnetic field $B_0$. The deflection is different for the two enantiomers of the chiral substance owing to the odd parity term of the space-dependent coupling tensor. As such, the deflection produces a difference in trajectory of the downward pointing net magnetisation for the two enantiomers, which in turn produces a difference in the FID recorded for the two enantiomers. By measuring this difference, it is possible to discriminate the enantiomers.

Depending on the angle $\theta$ by which the net magnetisation is flipped, different situations arise:
In **Figure 3b),** the net magnetisation is flipped by $\theta = \pi/2$. As in **Figure 3a),** the FID recorded is the same for the two enantiomers of the chiral substance. As a result, the NMR spectrum obtained after conducting FT is also the same for the two enantiomers of the chiral substance. Consequently, discrimination of the enantiomers is not possible.

In **Figure 3c),** the net magnetisation is flipped by $\theta = \pi$. Without any chiral perturbation, doing so would result in the net magnetisation to be aligned along the -Z-axis, i.e., aligned opposite to the direction of the static magnetic field $B_0$ of the NMR spectrometer, with the consequence that no FID can be recorded in the transversal XY-plane. Here, due to the chiral perturbation, the FID recorded for the two enantiomers of the chiral substance has the same magnitude but is opposite in phase. As a result, their signal phases cancel out, i.e., the net signal phase becomes zero, and there is no signal observable in the NMR spectrum obtained after conducting FT on the FID recorded. However, if the two enantiomers of the chiral substance are present in the sample as a non-racemic mixture, their signal phases do not cancel out, i.e., the net signal phase does not become zero, with the result that there is a signal observable in the NMR spectrum obtained after conducting FT on the FID recorded. The strength of the signal observable in the NMR spectrum depends on the ratio of the two enantiomers, also referred to as enantiomeric ratio. Consequently, discrimination of the enantiomers is possible.

In **Figure 3d),** the net magnetisation is flipped by $\pi/2 < \theta < \pi$. The FID recorded for the two enantiomers of the chiral substance has the same phase but varies in magnitude, which means that their signal phases do not cancel out, i.e., the net signal phase does not become zero. As a result, there is a signal observable in the NMR spectrum obtained after conducting FT on the FID recorded. As in **Figure 3c),** the strength of the signal observable in the NMR spectrum depends on the enantiomeric ratio. Consequently, discrimination of the enantiomers is possible.

As long as the net magnetisation of the sample is flipped from its initial position along the direction of the static magnetic field $B_0$ of the NMR spectrometer by an angle $\theta \neq (k - 1/2) \times \pi$, k being a nonzero positive integer, the angle $\theta$ is not further limited. Depending on the molecular structure of the chiral substance, the magnitude of the **space-dependent** coupling tensor may happen to be particularly low. In such a case, to still produce a measurable difference in the FID recorded for the two enantiomers, satisfying $\theta = k \times \pi$, k being a nonzero positive integer, may be an option as the difference in trajectory of the downward pointing net magnetisation produced becomes maximum for $\pi$, $2\pi$, $3\pi$, etc. On the other hand, if the magnitude of the space-dependent coupling tensor is sufficiently high, a difference in the FID recorded for the two enantiomers is also measurable for $(k - 1/2) \times \pi < \theta < k \times \pi$, k being a nonzero positive integer.

As far as the value of k is concerned, it is understood that the length of the RF magnetic field pulse increases when k increases. By increasing the pulse length, it is possible to accumulate the enantiomerically induced change in net signal phase. Doing so may help to still produce a measurable difference in the FID recorded for the two enantiomers in case the magnitude of the space-dependent coupling tensor may happen to be particularly low. However, when the RF magnetic field pulse is excessively long, the band of frequencies may become excessively small. Besides, there is an increasing tendency of dephasing already before the nuclear spins return to equilibrium. For instance, k may be 1. This value may be taken as a starting point for the measurement. Once it turns out that there is no difference measurable in the FID recorded for the two enantiomers, k may be increased, as appropriate. As found by the present inventors, when k ranges from 1 to 10, e.g., ranges from 1 to 5, it is possible to maintain the homogeneity of the RF magnetic field in the FID recorded.

In step (d) of the method according to the present invention, a change in net signal phase along the direction of the RF magnetic field $B_1(t)$ is detected by means of a detection unit. The detection unit is not further limited as long as it is capable of recording the FID. As described above, the first set of striplines may be further adapted to detect a change in net signal phase along the direction of the RF magnetic field $B_1(t)$. That is, in the method according to the present invention, the change in net signal phase along the direction of the RF magnetic field $B_1(t)$ may be detected by means of the first set of striplines as the detection unit. Then, the first set of striplines acts both as an RF transmitter and as an RF receiver.

In step (e) of the method according to the present invention, the enantiomers of the chiral substance are discriminated by means of a discrimination unit. Based on the change in net signal phase detected, the discrimination unit outputs which of the two enantiomers is/are contained in the sample, and optionally outputs the amount of the respective enantiomer contained in the sample. That is, discrimination of the enantiomers by means of the discrimination unit may be done qualitatively or quantitatively. For a quantitative discrimination, a series of calibration measurements may be performed in advance to find out how the change in net signal phase along the direction of the RF magnetic field $B_1(t)$, or alternatively how the strength of the signal observable in the NMR spectrum obtained after conducting FT on the FID recorded, depends on the enantiomeric ratio when applying the RF electric field pulse simultaneously with the RF magnetic field pulse. Typically, the discrimination unit is a computer that is in communication with the detection unit. As such, the discrimination unit is also capable of conducting FT on the FID recorded.

In case the discrimination of the enantiomers shall be done quantitatively, step (e) may comprise determining the enantiomeric excess of either one of the two enantiomers thereof. As known to the skilled person, the enantiomeric excess (ee) is calculated as follows:

$$ee = \left| n_1 - n_2 \right| / (n_1 + n_2)$$

In the above formula, $n_1$ represents the molar amount of one of the two enantiomers and $n_2$ represents the molar amount of the other one of the two enantiomers of the chiral substance contained in the sample under investigation. As known to the skilled person, the enantiomeric excess is related to the enantiomeric ratio (er) as follows:

$$er = n_1 / n_2 = (1 + ee) / (1 - ee)$$

$$ee = \left| er - 1 \right| / (er + 1)$$

When the enantiomers of the chiral substance are present in the sample as a racemic mixture, i.e., $n_1 = n_2$, the enantiomeric ratio amounts to one. In line with this, the enantiomeric excess amounts to zero. Instead of their molar amounts $n_1$ and $n_2$, the molar ratios $x_1$ and $x_2$ of the two enantiomers can be used for calculating the enantiomeric excess as well as the enantiomeric ratio. Furthermore, it is also possible to express the enantiomeric excess as well as the enantiomeric ratio in terms of the masses $m_1$ and $m_2$ of the two enantiomers, taking into account that the molecular weight thereof is identical.

In a specific embodiment, the present invention can be extended to the discrimination of a racemic mixture from a non-chiral substance, which is not possible with the techniques reported in the art. For doing so, the RF magnetic field pulse is augmented by an additional flip angle -F which is about the order of the expected chiral offset angle. For the racemic mixture, this will then cause the first enantiomer's signal to align with the -Z-axis while causing the second enantiomer to gain the double flip angle due to the chiral perturbation, which means that its signal amplitude will be doubled. Its signal phase will be in phase with the normal NMR signal phase, which is also recorded. In a subsequent measurement, the RF magnetic field pulse is augmented by an additional flip angle +F. For the racemic mixture, this will then cause the second enantiomer's signal to align with the -Z-axis while causing the first enantiomer to gain the double flip angle due to the chiral perturbation, which means that its signal amplitude will be doubled. However, its signal phase will now be $\pi$ out of phase with the normal NMR signal phase, which is also recorded. This difference in phase angle, i.e., 0 versus $\pi$, reveals that the signal of the sample is that of a racemic mixture. In case of the non-chiral substance, the additional flip angles -F and +F will, in both cases, result in identical signal amplitudes at identical phase angles, revealing that the signal of the sample is not that of a racemic mixture, but the signal of a non-chiral substance.

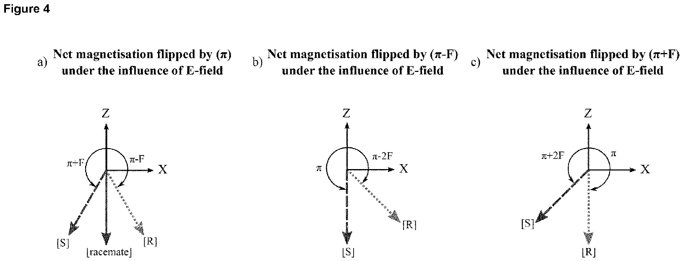

For the sake of illustration, reference is made to **Figure 4** where the specific embodiment described above is depicted.

As shown in **Figure 4a)**, when the net magnetisation of the racemic mixture is flipped by $\pi$ under the influence of the RF electric field, the net magnetisation of the first enantiomer, referred as [S], and the net magnetisation of the second enantiomer, referred to as [R], deviate from the -Z-axis by an angle $\pm$F. The FID recorded will result in their signal phases cancelling out. As shown in **Figure 4b)**, when the net magnetisation of the racemic mixture is flipped by $(\pi - F)$ under the influence of the same RF electric field, the net magnetisation of [S] aligns with the -Z-axis and the net magnetisation of [R] deviates from the -Z-axis by an angle -2F. The FID recorded will be proportional to -2F since the projection along the -Z-axis results in no signal. As shown in **Figure 4c)**, when the net magnetisation of the racemic mixture is flipped by $(\pi + F)$ under the influence of the same RF electric field, the net magnetisation of [R] aligns with the -Z-axis and the net magnetisation of [S] deviates from the -Z-axis by an angle +2F. The FID recorded will be proportional to +2F since the projection along the -Z-axis results in no signal. However, it will be opposite in phase with respect to the FID recorded in **Figure 4b)**. If the measurements are repeated with a non-chiral substance, the FID recorded when the flip angle is augmented by $\pm$F will be proportional to $\pm$F, which allows to discriminate the racemic mixture from the non-chiral substance.

The method according to the present invention, which employs the NMR detector assembly according to the present invention, is particularly suited for liquid samples. However, it is not limited thereto. Also in solids, there is a coupling between the electric and magnetic dipoles when applying an RF electric field pulse simultaneously with the RF magnetic field pulse, giving rise to a chiral perturbation which is characterized by different spin dynamics of the enantiomers. Accordingly, by detecting the enantiomerically induced change in net signal phase arising due to the chiral perturbation, it is possible to discriminate the enantiomers of the chiral substance also for solid samples. Unlike in liquid-state NMR where the spin interactions are isotropic as a result of the rapid tumbling motion of the nuclei, the spin interactions in solid-state NMR are anisotropic. Thus, to remove this anisotropy and to improve the resolution as well as the sensitivity of solid-state NMR, additional measures may be taken, such as magic angle spinning, which involves spinning the sample under investigation at an angle of arccos $1/3^{0.5}$ with respect to the direction of the static magnetic field $B_0$ of the NMR spectrometer. Magic angle spinning is well known to the skilled person and may be adopted as required.

By making advantage of the chiral perturbation that results from the coupling between the electric and magnetic dipoles when applying an RF electric field pulse simultaneously with the RF magnetic field pulse, it is not required to convert the enantiomers of the chiral substance into diastereomers for discriminating the same. In other words, it is not required to use any chiral derivatizing agents or chiral solvating agents. As mentioned above, their use is disadvantageous in many ways. Thus, it is preferred that the sample does not contain a chiral derivatizing agent or a chiral solvating agent.

In still another aspect, the present invention relates to a computer-program product for discriminating the enantiomers of a chiral substance contained in a sample, wherein the computer-program product comprises computer-readable instructions, which when loaded and run by a processor of an electronic device, cause the electronic device to carry out the following steps with the proviso that the sample containing the chiral substance has been placed into the sample probing region of the NMR detector assembly according to the present invention, and the NMR detector assembly has been inserted in the NMR spectrometer in such a way that each of the RF magnetic field $B_1(t)$ and the RF electric field $E_2(t)$ are perpendicular to the static magnetic field $B_0$ of the NMR spectrometer in the sample probing region:

(b) applying, by means of the first set of striplines of the NMR detector assembly, an RF magnetic field pulse along the direction of the RF magnetic field $B_1(t)$ to flip the net magnetisation of the sample from its initial position along the direction of the static magnetic field $B_0$ of the NMR spectrometer by an angle $\theta \neq (k - 1/2) \times \pi$, k being a nonzero positive integer;

(c) applying, by means of the second set of striplines of the NMR detector assembly, an RF electric field pulse along the direction of the RF electric field $E_2(t)$ simultaneously with the RF magnetic field pulse along the direction of the RF magnetic field $B_1(t)$;

(d) detecting, by means of a detection unit, a change in net signal phase along the direction of the RF magnetic field $B_1(t)$; and

(e) discriminating, by means of a discrimination unit, the enantiomers of the chiral substance based on the change in net signal phase detected.

The above-defined computer-program product for discriminating the enantiomers of a chiral substance contained in a sample, hereinafter simply referred to as computer-program product according to the present invention, employs the NMR detector assembly according to the present invention. Besides, steps (b) to (e) of the computer-program product according to the present invention are identical to steps (b) to (e) of the method according to the present invention. Thus, wherever applicable, for the computer-program product according to the present invention, the same definitions and limitations apply as given above for the NMR detector assembly according to the present invention as well as for the method according to the present invention, and *vice versa*.

The Figures show

Figure 1 shows a schematic of an exemplary NMR detector assembly according to the present invention.

Figure 2 shows a photograph of an exemplary NMR detector assembly according to the present invention.

Figure 3 shows the evolution of net magnetisation for different scenarios after applying the RF magnetic field pulse, and further shows the respective NMR spectra obtained.

Figure 4 shows the augmentation of the RF magnetic field pulse by an additional flip angle $\pm F$ for discriminating a racemic mixture from a non-chiral substance.

Figure 5 shows the comparison of $^{19}$F-NMR spectra obtained for 1,1,1-trifluoropropan-2-ol either as a racemic mixture or in enantiomerically pure form under different conditions.

Figure 6 shows the comparison of $^{1}$H-NMR spectra obtained for 1,1,1-trifluoropropan-2-ol either as a racemic mixture or in enantiomerically pure form under different conditions.

Examples

The present invention is further illustrated by the following Examples without, however, being limited thereto.

For the experiments presented herein, an NMR detector assembly such as the one described above in detail in connection with Figures 1 and 2 was implemented by precision printed circuit board technology as a stack of four striplines sandwiching the sample probing region. The measurements were performed on a vertical wide-bore superconducting NMR spectrometer (Bruker AVANCE III) having the NMR detector assembly inserted therein. For this purpose, the NMR detector assembly was mounted on a customized NMR probehead (Voxalytic GmbH). The static magnetic field $B_0$ of the NMR spectrometer had a magnitude of 11.74 T. For the $^{19}$F-NMR measurements presented below, the magnitude of the RF magnetic field $B_1(t)$ was approximately 0.9 mT and the magnitude of the RF electric field $E_2(t)$ was approximately 26 kV·m$^{-1}$ at a power of 20 W, respectively.

As the chiral substance, 1,1,1-trifluoropropan-2-ol with its (R)- and (S)-enantiomers was selected as a model system in view of the relatively high magnitude of its electric dipole moment, which should in turn give rise to a relatively high magnitude of the space-dependent coupling tensor. Two liquid samples were prepared, one containing a racemic mixture of the (R)- and (S)-enantiomers, the other one containing only the (R)-enantiomer with the same molar amount of 1,1,1-trifluoropropan-2-ol. The samples were prepared identically, ensuring that the sample volumes were the same (2.94 μL). Further, it was ensured that the shimming values were within an acceptable range from each other such that no deviation in the NMR lineshape was observed.

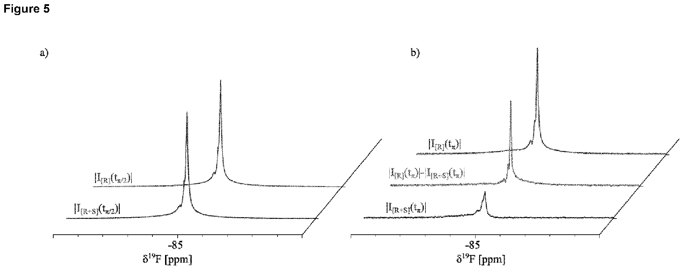

Performing $^{19}$F-NMR measurements, the signal intensity from the fluorine atoms belonging to the trifluoromethyl group of the (R)-enantiomer was compared with that of the racemic mixture. The results are shown in Figure 5.

Figure 5a) shows the signal intensity acquired by applying a $\pi/2$-pulse in the presence of the RF electric field $E_2(t)$, and Figure 5b) shows the signal intensity acquired by applying a pulse close to $\pi$ in the presence of the RF electric field $E_2(t)$. It can be recognized that the signal intensities were the same for the racemic mixture and the (R)-enantiomer when applying the $\pi/2$-pulse. In contrast, when applying the pulse close to $\pi$, the signal intensities were different. Specifically, for the racemic mixture, the signal intensity when applying the pulse close to $\pi$ was reduced to 8% of the signal intensity when applying the $\pi/2$-pulse.

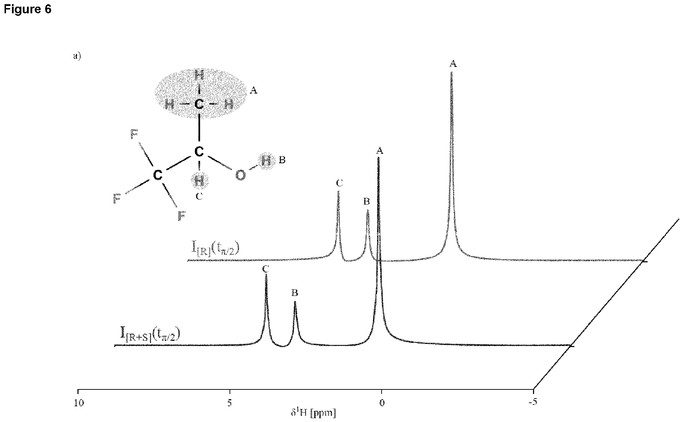

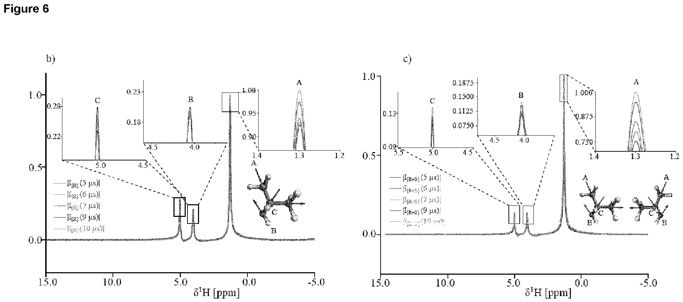

To get further insight, $^{1}$H-NMR measurements were performed for the samples under investigation. The signal intensities from the hydrogen atoms belonging to the methyl group, to the hydroxy group and to the methine group, labeled as A, B and C, respectively, of the (R)-enantiomer were compared with those of the racemic mixture. The results are shown in Figure 6.

Figure 6a) shows the signal intensities acquired by applying a $\pi/2$-pulse in the presence of the RF electric field $E_2(t)$. It can be recognized that the relative signal intensities of the two peaks B and C compared to peak A were different for the racemic mixture and the (R)-enantiomer. Here, the variation in signal intensities was attributed to various factors such as sample volume, tuning and matching, temperature, shim, etc.

Figure 6b) shows the signal intensities acquired by applying a pulse close to $\pi$ in the presence of the RF electric field $E_2(t)$ for the (R)-enantiomer, and Figure 6c) shows the signal intensities acquired by applying a pulse close to $\pi$ in the presence of the RF electric field $E_2(t)$ for the racemic mixture. In both cases, the length of the RF electric field pulse was varied. It can be recognized from Figure 6b) that the signal intensity of peak A increased with increasing pulse length while the signal intensities of peaks B and C decreased with increasing pulse lengths. On the other hand, as can be recognized from Figure 6c), each of the signal intensities of peaks A, B and C increased with increasing pulse lengths. In Figures 6b) and c), the arrows indicate the directions of the electric dipole moment (not scaled to actual values). Since the electric dipole moment is different at the hydrogen atoms belonging to the methyl group, to the hydroxy group and to the methine group, the space-dependent coupling tensor varies for the respective hydrogen atoms. This in turn explains why the signal intensities of peaks A, B and C behaved differently with increasing pulse lengths.

As demonstrated hereinabove, by applying a specific pulse sequence, it is possible to discriminate the enantiomers of a chiral substance. For doing so, it is necessary that any stray electric and magnetic fields are minimized, which is achieved by the specific stripline-based configuration of the NMR detector assembly. Based on these findings, the above technical problem underlying the present invention has been solved.

**Claims**

1. **An NMR** detector assembly for discriminating the enantiomers of a chiral substance contained in a sample, the NMR detector assembly being adapted to be inserted in an NMR spectrometer and comprising:

   a first set of striplines, a second set of striplines and a sample probing region,
   the NMR detector assembly being adapted to create a time-dependent RF magnetic field $B_1(t)$ in the form of an RF magnetic field pulse along the direction of the RF magnetic field $B_1(t)$ by means of the first set of striplines such that the net magnetisation of the sample is flipped from its initial position along the direction of the static magnetic field $B_0$ of the NMR spectrometer by an angle $\theta \neq (k - 1/2) \times \pi$, k being a nonzero positive integer,
   and adapted to create a time-dependent RF electric field $E_2(t)$ perpendicular to the RF magnetic field $B_1(t)$ in the form of an RF electric field pulse along the direction of the RF electric field

$E_2(t)$ simultaneously with the RF magnetic field pulse along the direction of the RF magnetic field $B_1(t)$ by means of the second set of striplines;
the sample probing region being located at the intersection of the RF magnetic field $B_1(t)$ and the RF electric field $E_2(t)$,
wherein the NMR detector assembly is adapted to be inserted in the NMR spectrometer in such a way that each of the RF magnetic field $B_1(t)$ and the RF electric field $E_2(t)$ are perpendicular to the static magnetic field $B_0$ of the NMR spectrometer in the sample probing region.

2. The NMR detector assembly according to claim 1, wherein the first set of striplines and the second set of striplines are arranged in a stacked manner and symmetrically sandwich the sample probing region, the first set of striplines being closer to the sample probing region than the second set of striplines.

3. The NMR detector assembly according to claim 1 or 2, wherein the size of the second set of striplines is such that it covers at least the entire length and width of the first set of striplines.

4. The **NMR** detector assembly according to any one of claims 1 to 3, wherein the second set of striplines is adapted to create the RF electric field $E_2(t)$ up to the minimum dielectric strength of the medium through which the RF electric field $E_2(t)$ passes.

5. The NMR detector assembly according to any one of claims 1 to 4, wherein the NMR detector assembly is adapted in such a way that the first set of striplines and the second set of striplines are electrically controlled individually.

6. The NMR detector assembly according to any one of claims 1 to 5, wherein the first set of striplines is further adapted to detect a change in net signal phase along the direction of the RF magnetic field $B_1(t)$.

7. The NMR detector assembly according to claim 6, wherein the NMR detector assembly does not contain any means for detecting a change in net signal phase other than the first set of striplines.

8. A method for discriminating the enantiomers of a chiral substance contained in a sample, the method comprising the following steps:

   (a) placing the sample containing the chiral substance into the sample probing region of the NMR detector assembly according to any one of claims 1 to 7, and inserting the NMR detector assembly in the NMR spectrometer in such a way that each of the RF magnetic field $B_1(t)$ and

the RF electric field $E_2(t)$ are perpendicular to the static magnetic field $B_0$ of the NMR spectrometer in the sample probing region;

(b) applying, by means of the first set of striplines of the NMR detector assembly, an RF magnetic field pulse along the direction of the RF magnetic field $B_1(t)$ to flip the net magnetisation of the sample from its initial position along the direction of the static magnetic field $B_0$ of the NMR spectrometer by an angle $\theta \neq (k - 1/2) \times \pi$, k being a nonzero positive integer;

(c) applying, by means of the second set of striplines of the NMR detector assembly, an RF electric field pulse along the direction of the RF electric field $E_2(t)$ simultaneously with the RF magnetic field pulse along the direction of the RF magnetic field $B_1(t)$;

(d) detecting, by means of a detection unit, a change in net signal phase along the direction of the RF magnetic field $B_1(t)$; and

(e) discriminating, by means of a discrimination unit, the enantiomers of the chiral substance based on the change in net signal phase detected.

9. The method according to claim 8, wherein the RF electric field $E_2(t)$ is up to the minimum dielectric strength of the medium through which the RF electric field $E_2(t)$ passes.

10. The method according to claim 8 or 9, wherein $\theta = k \times \pi$, k being a nonzero positive integer.

11. The method according to any one of claims 8 to 10, wherein the change in net signal phase along the direction of the RF magnetic field $B_1(t)$ is detected by means of the first set of striplines as the detection unit.

12. The method according to any one of claims 8 to 11, wherein step (e) comprises determining the enantiomeric excess of either one of the two enantiomers thereof.

13. The method according to any one of claims 8 to 12, wherein the sample is a liquid sample.

14. The method according to any one of claims 8 to 13, wherein the sample does not contain a chiral derivatizing agent or a chiral solvating agent.

15. A computer-program product for discriminating the enantiomers of a chiral substance contained in a sample, wherein the computer-program product comprises computer-readable instructions, which when loaded and run by a processor of an electronic device, cause the electronic device to carry out the following steps with the proviso that the sample containing the chiral substance has been placed into the sample probing region of the NMR detector assembly according to any one of claims 1 to 7, and the NMR detector assembly has been inserted in the NMR spectrometer in such a way that each of the RF magnetic field $B_1(t)$ and the RF electric field $E_2(t)$ are perpendicular to the static magnetic field $B_0$ of the NMR spectrometer in the sample probing region:

(b) applying, by means of the first set of striplines of the NMR detector assembly, an RF magnetic field pulse along the direction of the RF magnetic field $B_1(t)$ to flip the net magnetisation of the sample from its initial position along the direction of the static magnetic field $B_0$ of the NMR spectrometer by an angle $\theta \neq (k - 1/2) \times \pi$, k being a nonzero positive integer;

(c) applying, by means of the second set of striplines of the NMR detector assembly, an RF electric field pulse along the direction of the RF electric field $E_2(t)$ simultaneously with the RF magnetic field pulse along the direction of the RF magnetic field $B_1$;

(d) detecting, by means of a detection unit, a change in net signal phase along the direction of the RF magnetic field $B_1(t)$; and

(e) discriminating, by means of a discrimination unit, the enantiomers of the chiral substance based on the change in net signal phase detected.

**Patentansprüche**

1. NMR-Detektoranordnung zum Unterscheiden der Enantiomere einer chiralen Substanz, welche in einer Probe enthalten ist, wobei die NMR-Detektoranordnung eingerichtet ist, in ein NMR-Spektrometer eingesetzt zu werden, und umfasst:

einen ersten Satz von Striplines, einen zweiten Satz von Striplines und einen Probenmessbereich,

wobei die NMR-Detektoranordnung eingerichtet ist, ein zeitabhängiges hochfrequentes Magnetfeld $B_1(t)$ in Form eines hochfrequenten Magnetfeldpulses entlang der Richtung des hochfrequenten Magnetfeldes $B_1(t)$ mittels des ersten Satzes von Striplines derart zu erzeugen, dass die Nettomagnetisierung der Probe aus ihrer Ursprungsposition entlang der Richtung des statischen Magnetfeldes $B_0$ des NMR-Spektrometers um einen Winkel $\theta \neq (k - 1/2) \times \pi$, worin k eine positive ganze Zahl ungleich null ist, ausgelenkt wird,

und eingerichtet ist, ein zeitabhängiges hochfrequentes elektrisches Feld $E_2(t)$ senkrecht zu

dem hochfrequenten Magnetfeld $B_1(t)$ in Form eines hochfrequenten elektrischen Feldpulses entlang der Richtung des hochfrequenten elektrischen Feldes $E_2(t)$ zeitgleich mit dem hochfrequenten Magnetfeldpuls entlang der Richtung des hochfrequenten Magnetfeldes $B_1(t)$ mittels des zweiten Satzes von Striplines zu erzeugen,

wobei sich der Probenmessbereich an der Kreuzung des hochfrequenten Magnetfeldes $B_1(t)$ und des hochfrequenten elektrischen Feldes $E_2(t)$ befindet,

wobei die NMR-Detektoranordnung eingerichtet ist, derart in das NMR-Spektrometer eingesetzt zu werden, dass das hochfrequente Magnetfeld $B_1(t)$ und das hochfrequente elektrische Feld $E_2(t)$ jeweils senkrecht zu dem statischen Magnetfeld $B_0$ des NMR-Spektrometers in dem Probenmessbereich stehen.

2.  NMR-Detektoranordnung nach Anspruch 1, wobei der erste Satz von Striplines und der zweite Satz von Striplines in einer gestapelten Weise angeordnet sind und den Probenmessbereich symmetrisch zwischen sich anordnen, wobei sich der erste Satz von Striplines näher an dem Probenmessbereich befindet als der zweite Satz von Striplines.

3.  NMR-Detektoranordnung nach Anspruch 1 oder 2, wobei die Größe des zweiten Satzes von Striplines derart bemessen ist, dass er wenigstens die gesamte Länge und Breite des ersten Satzes von Striplines abdeckt.

4.  NMR-Detektoranordnung nach einem der Ansprüche 1 bis 3, wobei der zweite Satz von Striplines eingerichtet ist, das hochfrequente elektrische Feld $E_2(t)$ bis zu der minimalen Durchschlagsfestigkeit des Mediums, durch welches das hochfrequente elektrische Feld $E_2(t)$ tritt, zu erzeugen.

5.  NMR-Detektoranordnung nach einem der Ansprüche 1 bis 4, wobei die NMR-Detektoranordnung derart eingerichtet ist, dass der erste Satz von Striplines und der zweite Satz von Striplines individuell elektronisch geregelt werden.

6.  NMR-Detektoranordnung nach einem der Ansprüche 1 bis 5, wobei der erste Satz von Striplines weiter eingerichtet ist, eine Änderung in der Nettosignalphase entlang der Richtung des hochfrequenten Magnetfeldes $B_1(t)$ zu detektieren.

7.  NMR-Detektoranordnung nach Anspruch 6, wobei die NMR-Detektoranordnung außer dem ersten Satz von Striplines kein Mittel zum Detektieren einer Änderung in der Nettosignalphase enthält.

8.  Verfahren zum Unterscheiden der Enantiomere einer chiralen Substanz, welche in einer Probe enthalten ist, wobei das Verfahren die nachstehenden Schritte umfasst:

    (a) Einbringen der Probe, welche die chirale Substanz enthält, in den Probenmessbereich der NMR-Detektoranordnung nach einem der Ansprüche 1 bis 7 und Einsetzen der NMR-Detektoranordnung in das NMR-Spektrometer dergestalt, dass das hochfrequente Magnetfeld $B_1(t)$ und das hochfrequente elektrische Feld $E_2$ $(t)$ jeweils senkrecht zu dem statischen Magnetfeld $B_0$ des NMR-Spektrometers in dem Probenmessbereich stehen;
    (b) Anlegen, mittels des ersten Satzes von Striplines der NMR-Detektoranordnung, eines hochfrequenten Magnetfeldpulses entlang der Richtung des hochfrequenten Magnetfeldes $B_1$ $(t)$, um die Nettomagnetisierung der Probe aus ihrer Ursprungsposition entlang der Richtung des statischen Magnetfeldes $B_0$ des NMR-**Spektrometers** um einen Winkel $\theta \neq (k - 1/2) \times \pi$, worin $k$ eine positive ganze Zahl ungleich null ist, auszulenken;
    (c) Anlegen, mittels des zweiten Satzes von Striplines der NMR-Detektoranordnung, eines hochfrequenten elektrischen Feldpulses entlang der Richtung des hochfrequenten elektrischen Feldes $E_2(t)$ zeitgleich mit dem hochfrequenten Magnetfeldpuls entlang der Richtung des hochfrequenten Magnetfeldes $B_1(t)$;
    (d) Detektieren, mittels einer Detektionseinheit, einer Änderung in der Nettosignalphase entlang der Richtung des hochfrequenten Magnetfeldes $B_1(t)$; und
    (e) Unterscheiden, mittels einer Unterscheidungseinheit, der Enantiomere der chiralen Substanz auf Grundlage der detektierten Änderung in der Nettosignalphase.

9.  Verfahren nach Anspruch 8, wobei das hochfrequente elektrische Feld $E_2(t)$ bis zu der minimalen Durchschlagsfestigkeit des Mediums, durch welches das hochfrequente elektrische Feld $E_2(t)$ tritt, reicht.

10. Verfahren nach Anspruch 8 oder 9, wobei $\theta = k \times \pi$, worin $k$ eine positive ganze Zahl ungleich null ist.

11. Verfahren nach einem der Ansprüche 8 bis 10, wobei die Änderung in der Nettosignalphase entlang der Richtung des hochfrequenten Magnetfeldes $B_1(t)$ mittels des ersten Satzes von Striplines als die Detektionseinheit detektiert wird.

12. Verfahren nach einem der Ansprüche 8 bis 11, wobei Schritt (e) das Bestimmen des Enantiomerenüberschusses eines der beiden Enantiomere davon umfasst.

13. Verfahren nach einem der Ansprüche 8 bis 12, wobei die Probe eine flüssige Probe ist.

14. Verfahren nach einem der Ansprüche 8 bis 13, wobei die Probe weder ein chirales Derivatisierungsreagenz noch ein chirales Lösungsmittel enthält.

15. Computerprogrammerzeugnis zum Unterscheiden der Enantiomere einer chiralen Substanz, welche in einer Probe enthalten ist, wobei das Computerprogrammerzeugnis computerlesbare Anweisungen umfasst, welche, wenn sie von einem Prozessor einer elektronischen Vorrichtung geladen und ausgeführt werden, die elektronische Vorrichtung veranlassen, die nachstehenden Schritte durchzuführen, mit der Maßgabe, dass die Probe, welche die chirale Substanz enthält, in den Probenmessbereich der NMR-Detektoranordnung nach einem der Ansprüche 1 bis 7 eingebracht worden ist und die NMR-Detektoranordnung derart in das NMR-Spektrometer eingesetzt worden ist, dass das hochfrequente Magnetfeld $B_1(t)$ und das hochfrequente elektrische Feld $E_2(t)$ jeweils senkrecht zu dem statischen Magnetfeld $B_0$ des NMR-Spektrometers in dem Probenmessbereich stehen:

(b) Anlegen, mittels des ersten Satzes von Striplines der NMR-Detektoranordnung, eines hochfrequenten Magnetfeldpulses entlang der Richtung des hochfrequenten Magnetfeldes $B_1(t)$, um die Nettomagnetisierung der Probe aus ihrer Ursprungsposition entlang der Richtung des statischen Magnetfeldes $B_0$ des NMR-Spektrometers um einen Winkel $\theta \neq (k - 1/2) \times \pi$, worin k eine positive ganze Zahl ungleich null ist, auszulenken;

(c) Anlegen, mittels des zweiten Satzes von Striplines der NMR-Detektoranordnung, eines hochfrequenten elektrischen Feldpulses entlang der Richtung des hochfrequenten elektrischen Feldes $E_2(t)$ zeitgleich mit dem hochfrequenten Magnetfeldpuls entlang der Richtung des hochfrequenten Magnetfeldes $B_1$;

(d) Detektieren, mittels einer Detektionseinheit, einer Änderung in der Nettosignalphase entlang der Richtung des hochfrequenten Magnetfeldes $B_1(t)$; und

(e) Unterscheiden, mittels einer Unterscheidungseinheit, der Enantiomere der chiralen Substanz auf Grundlage der detektierten Änderung in der Nettosignalphase.

**Revendications**

1. Ensemble de détecteur à RMN pour établir la distinction entre les énantiomères d'une substance chirale contenue dans un échantillon, l'ensemble de détecteur à RMN étant adapté à être inséré dans un spectromètre RMN et comprenant :

un premier ensemble de guides d'ondes à rubans, un second ensemble de guides d'ondes à rubans et une région de sondage d'échantillon, l'ensemble de détecteur à RMN étant adapté à créer un champ magnétique RF à dépendance temporelle $B_1(t)$ sous la forme d'une impulsion de champ magnétique RF le long de la direction du champ magnétique RF $B_1(t)$ au moyen du premier ensemble de guides d'ondes à rubans de sorte que l'aimantation nette de l'échantillon est retournée de sa position initiale le long de la direction du champ magnétique statique $B_0$ du spectromètre RMN d'un angle $\theta \neq (k - 1/2) \times \pi$, k étant un entier positif non nul, et adapté à créer un champ électrique RF à dépendance temporelle $E_2(t)$ perpendiculaire au champ magnétique $B_1(t)$ sous la forme d'une impulsion de champ électrique RF le long de la direction du champ électrique RF $E_2(t)$ simultanément à l'impulsion de champ magnétique RF le long de la direction du champ magnétique RF $B_1(t)$ au moyen du second ensemble de guides d'ondes à rubans ; la région de sondage d'échantillon étant située à l'intersection du champ magnétique RF $B_1(t)$ et du champ électrique RF $E_2(t)$, dans lequel l'ensemble de détecteur à RMN est adapté à être inséré dans le spectromètre RMN de telle sorte que chacun du champ magnétique RF $B_1(t)$ et du champ électrique RF $E_2(t)$ est perpendiculaire au champ magnétique statique $B_0$ du spectromètre RMN dans la région de sondage d'échantillon.

2. Ensemble de détecteur à RMN selon la revendication 1, dans lequel le premier ensemble de guides d'ondes à rubans et le second ensemble de guides d'ondes à rubans sont agencés de manière empilée et prennent en sandwich symétriquement la région de sondage d'échantillon, le premier ensemble de guides d'ondes à rubans étant plus proche de la région de sondage d'échantillon que le second ensemble de guides d'ondes à rubans.

3. Ensemble de détecteur à RMN selon la revendication 1 ou 2, dans lequel la taille du second ensemble de guides d'ondes à rubans est telle qu'elle couvre au moins les longueur et largeur entières du premier ensemble de guides d'ondes à rubans.

**4.** Ensemble de détecteur à RMN selon l'une quelconque des revendications 1 à 3, dans lequel le second ensemble de guides d'ondes à rubans est adapté à créer le champ électrique RF $E_2(t)$ jusqu'à la rigidité diélectrique minimale du milieu à travers lequel le champ électrique RF $E_2(t)$ passe.

**5.** Ensemble de détecteur à RMN selon l'une quelconque des revendications 1 à 4, dans lequel l'ensemble de détecteur à RMN est adapté de telle sorte que le premier ensemble de guides d'ondes à rubans et le second ensemble de guides d'ondes à rubans sont commandés électriquement individuellement.

**6.** Ensemble de détecteur à RMN selon l'une quelconque des revendications 1 à 5, dans lequel le premier ensemble de guides d'ondes à rubans est en outre adapté à détecter un changement de phase de signal nette le long de la direction du champ magnétique RF $B_1(t)$.

**7.** Ensemble de détecteur à RMN selon la revendication 6, dans lequel l'ensemble de détecteur à RMN ne contient pas de moyen pour détecter un changement de phase de signal nette autre que le premier ensemble de guides d'ondes à rubans.

**8.** Procédé pour établir la distinction entre les énantiomères d'une substance chirale contenue dans un échantillon, le procédé comprenant les étapes suivantes :

(a) placer l'échantillon contenant la substance chirale dans la région de sondage d'échantillon de l'ensemble de détecteur à RMN selon l'une quelconque des revendications 1 à 7, et insérer l'ensemble de détecteur à RMN dans le spectromètre RMN de telle sorte que chacun du champ magnétique RF $B_1(t)$ et du champ électrique RF $E_2(t)$ est perpendiculaire au champ magnétique statique $B_0$ du spectromètre RMN dans la région de sondage d'échantillon ;
(b) appliquer, au moyen du premier ensemble de guides d'ondes à rubans de l'ensemble de détecteur à RMN, une impulsion de champ magnétique RF le long de la direction du champ magnétique RF $B_1(t)$ pour retourner l'aimantation nette de l'échantillon de sa position initiale le long de la direction du champ magnétique statique $B_0$ du spectromètre RMN d'un angle $\theta \neq (k - 1/2) \times \pi$, k étant un entier positif non nul ;
(c) appliquer, au moyen du second ensemble de guides d'ondes à rubans de l'ensemble de détecteur à RMN, une impulsion de champ électrique RF le long de la direction du champ électrique RF $E_2(t)$ simultanément à l'impulsion de champ magnétique RF le long de la direction du champ magnétique RF $B_1(t)$ ;

(d) détecter, au moyen d'un module de détetion, un changement de phase de signal nette le long de la direction du champ magnétique RF $B_1(t)$ ; et
(e) établir la distinction, au moyen d'un module de discrimination, entre les énantiomères de la substance chirale en fonction du changement de phase de signal nette détecté.

**9.** Procédé selon la revendication 8, dans lequel le champ électrique RF $E_2(t)$ est jusqu'à la rigidité diélectrique minimale du milieu à travers lequel le champ électrique RF $E_2(t)$ passe.

**10.** Procédé selon la revendication 8 ou 9, dans lequel $\theta$ = k x $\pi$, k étant un entier positif non nul.

**11.** Procédé selon l'une quelconque des revendications 8 à 10, dans lequel le changement de phase de signal nette le long de la direction du champ magnétique RF $B_1(t)$ est détecté au moyen du premier ensemble de guides d'ondes à rubans en tant que module de détection.

**12.** Procédé selon l'une quelconque des revendications 8 à 11, dans lequel l'étape (e) comprend déterminer l'excès énantiomérique de l'un ou l'autre des deux énantiomères de celle-ci.

**13.** Procédé selon l'une quelconque des revendications 8 à 12, dans lequel l'échantillon est un échantillon liquide.

**14.** Procédé selon l'une quelconque des revendications 8 à 13, dans lequel l'échantillon ne contient pas d'agent de dérivation chirale ou d'agent de solvatation chirale.

**15.** Produit de programme informatique pour établir la distinction entre les énantiomères d'une substance chirale contenue dans un échantillon, dans lequel le produit de programme informatique comprend des instructions lisibles par ordinateur qui, lors de leur chargement et exécution par un processeur d'un dispositif électronique, amènent le dispositif électronique à réaliser les étapes suivantes à condition que l'échantillon contenant la substance chirale ait été placé dans la région de sondage d'échantillon de l'ensemble de détecteur à RMN selon l'une quelconque des revendications 1 à 7, et l'ensemble de détecteur à RMN ait été inséré dans le spectromètre RMN de telle sorte que chacun du champ magnétique RF $B_1(t)$ et du champ électrique RF $E_2(t)$ est perpendiculaire au champ magnétique statique $B_0$ du spectromètre RMN dans la région de sondage d'échantillon :

(b) appliquer, au moyen du premier ensemble de guides d'ondes à rubans de l'ensemble de détecteur à RMN, une impulsion de champ magnétique RF le long de la direction du champ magnétique RF $B_1(t)$ pour retourner l'aimantation nette de l'échantillon de sa position initiale le long de la direction du champ magnétique statique $B_0$ du spectromètre RMN d'un angle $\theta \neq (k - 1/2) \times \pi$, k étant un entier positif non nul ;

(c) appliquer, au moyen du second ensemble de guides d'ondes à rubans de l'ensemble de détecteur à RMN, une impulsion de champ électrique RF le long de la direction du champ électrique RF $E_2(t)$ simultanément à l'impulsion de champ magnétique RF le long de la direction du champ magnétique RF $B_1(t)$ ;

(d) détecter, au moyen d'un module de détetion, un changement de phase de signal nette le long de la direction du champ magnétique RF $B_1(t)$ ; et

(e) faire la distinction, au moyen d'un module de discrimination, entre les énantiomères de la substance chirale en fonction du changement de phase de signal nette détecté.

**Figure 1**

**Figure 2**

Figure 3

a) **Achiral**
**pulse length = $\pi/2$**

b) **Chiral**
**pulse length = $\pi/2$**

c) **Chiral**
**pulse length = $\pi$**

d) **Chiral**
**pulse length = $\pi/2 < \theta < \pi$**

**Figure 4**

a) **Net magnetisation flipped by ($\pi$) under the influence of E-field**

b) **Net magnetisation flipped by ($\pi$-F) under the influence of E-field**

c) **Net magnetisation flipped by ($\pi$+F) under the influence of E-field**

**Figure 5**

a)

$|I_{[R]}(t_{\pi/2})|$

$|I_{[R+S]}(t_{\pi/2})|$

-85
$\delta^{19}F$ [ppm]

b)

$|I_{[R]}(t_{\pi})|$

$|I_{[R]}(t_{\pi})|-|I_{[R+S]}(t_{\pi})|$

$|I_{[R+S]}(t_{\pi})|$

-85
$\delta^{19}F$ [ppm]

**Figure 6**

a)

**Figure 6**

# EP 4 650 764 B1

**Non-patent literature cited in the description**

- **BUCKINGHAM et al.** *Chemical Physics*, 2006, vol. 324, 111-116

- **P. J. M. VAN BENTUM et al.** Stripline probes for nuclear magnetic resonance. *Journal of Magnetic Resonance*, 2007, vol. 189, 104-113